Europäisches Patentamt

European Patent Office

Office européen des brevets

(11) Publication number: 0 213 693 B1

# EUROPEAN PATENT SPECIFICATION

(45) Date of publication of patent specification: 21.08.91    (51) Int. Cl.⁵: G03F 1/00

(21) Application number: 86304473.1

(22) Date of filing: 11.06.86

(54) Photomask material.

(30) Priority: 30.08.85 JP 192814/85
              30.08.85 JP 192815/85

(43) Date of publication of application:
     11.03.87 Bulletin 87/11

(45) Publication of the grant of the patent:
     21.08.91 Bulletin 91/34

(84) Designated Contracting States:
     CH DE FR GB LI NL

(56) References cited:
     EP-A- 0 073 136
     WO-A-82/00794

     PATENT ABSTRACTS OF JAPAN, vol. 6, no.
     262 (P-164)[1140], 21st December 1982; & JP-
     A-57 157 247 (NIPPON DENKI K.K.) 28-09-1982

     PATENT ABSTRACTS OF JAPAN, vol. 6, no.
     262 (P-164)[1140], 21st December 1982; & JP-
     A-57 157 249 (NIPPON DENKI K.K.) 28-09-1982

(73) Proprietor: MITSUBISHI DENKI KABUSHIKI
     KAISHA
     2-3, Marunouchi 2-chome Chiyoda-ku
     Tokyo 100(JP)

(72) Inventor: Watakabe, Yaichiro Mitsubishi Denki
     K.K. LSI
     Kenkyusho 1 Mizuhara 4-chome
     Itami-shi Hyogo-ken(JP)
     Inventor: Matsuda, Shuichi Mitsubishi Denki
     K.K. LSI
     Kenkyusho 1 Mizuhara 4-chome
     Itami-shi Hyogo-ken(JP)

(74) Representative: Wright, Peter David John et al
     R.G.C. Jenkins & Co. 26 Caxton Street
     London SW1H 0RJ(GB)

## Description

Field of the Invention

This invention relates to a photomask material and particularly to a photomask material to be used for manufacturing a semiconductor device.

Description of the Prior Art

As a mask to be used for manufacturing a semiconductor device, a photographic emulsion plate formed by a glass substrate was generally utilized in the early days. However, according to the tendency toward high integration with fine patterns, hard masks including a metallic thin film of such as chromium (Cr) formed on a transparent glass substrate are widely utilized these days (for example, see Japanese Patent Laying-Open Gazette No. 157247/1982 or 157249/1982).

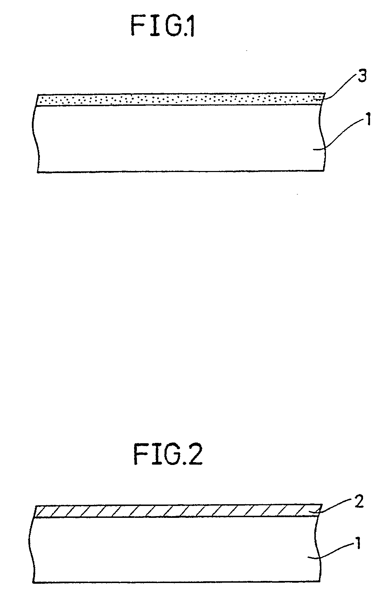

Fig. 2 is a sectional view of a conventional photomask material. In the figure, a metal film 2 of chromium or the like is formed on a transparent glass substrate 1 of quartz or the like. This metal film 2 of Cr or the like is formed to a thickness of approximately 600 to 800 Å on the transparent glass substrate 1 by an evaporation or sputtering process. In order that a photomask for semiconductor device may be obtained, photoresist or resist for electron beam (referred to hereinafter as EB) is coated on the metal film 2 and patterns are formed by irradiation of light or EB, and after that, a developing process and an etching process etc. are applied. If the metal film 2 is formed of Cr, etching is applied by using ceric antimony nitrate and perchloric acid in case of a wet process or a mixed gas of carbon tetrachloride (CCl₄) and oxygen (O₂) in case of a dry process. In manufacturing of a mask for a semiconductor device, particularly a highly integrated device having fine patterns such as VLSI, a dry etching process which produces little effect of side etching is preferred.

Although a wet etching process is generally adopted for manufacturing a Cr mask to be used as a mask for manufacturing a conventional semiconductor device, it is difficult in a wet etching process to obtain a mask of high precision due to a side etching effect and the like, while in a dry etching process, the etching speed of Cr is lower than approximately 100 Å/min and a ratio of selection of resist is not appropriate and, therefore, the dry etching process is not suited for mass production of photomasks. In addition, in the case of a Cr mask, adhesion to the quartz substrate is not good, causing fine patterns to peel off at the time of rinsing the mask.

As means for solving the above stated problems, a method might be considered in which a metal silicide film formed by a silicide transition metal of molybdenum (Mo), tantalum (Ta), tungsten (W) or the like is used as a mask material (for example, see Japanese Patent Application No. 61372/1984). More specifically, silicon (Si) contained in the quartz glass substrate and silicon (Si) contained in the metal silicide film as a mask material are effectively combined to produce strong adhesion. As for etching, dry etching can be easily done (at an etching speed of 1000 Å/min) by using mixed gas plasma containing carbon tetrafluoride (CF₄) and oxygen (O₂), compared with the case of a chromium (Cr) mask.

However, the above stated transition metal silicide film has a light reflection factor as high as approximately 50% and as a result, at the time of pattern printing, the resolution of the patterns is decreased due to diverse scattering of light between the wafer and the mask, which makes it difficult to manufacture a VLSI device having submicron patterns.

## SUMMARY OF THE INVENTION

It would be desirable to provide a photomask material of high quality having an excellent adhesive property with respect to a transparent substrate and a low reflection factor, dry etching being easily performed.

The present invention provides, in a first aspect, photomask material to be used for manufacturing a semiconductor device, comprising

a transparent substrate, and

a film of oxidized transition metal silicide formed over said transparent substrate.

The silicide film of oxidized transition metal formed over the transparent substrate has a low reflectance and in consequence, a high resolution can be obtained and dry etching can be easily done. In addition, since said silicide film has good adhesion to a transparent substrate, fine patterns can hardly peel off at the time of rinsing the mask.

In a second aspect of the present invention, there is provided a method of forming a photomask made from a transparent substrate (1) and a film of oxidised transition metal silicide (3,5) formed over said transparent substrate, wherein the film defines a semiconductor pattern on said substrate, said method including the step of exposing an area of said film of oxidised transition metal silicide to a plasma containing oxygen and a halocarbon so as to remove in said area, said transition metal and silicon as oxyhalides.

According to a third aspect of the present invention there is provided a photomask comprising a film of transition metal silicide (3) formed in a pattern over a transparent substrate (1) and a further film (4) formed over said film of transition metal silicide which is less reflective than said film of transition metal silicide.

These features, aspects and advantages of the present invention will become more apparent from the following detailed description of the present invention when taken in conjunction with the accompanying drawings.

BRIEF DESCRIPTION OF THE DRAWINGS

Fig. 1 is a sectional view showing a photomask material of an embodiment of this invention;
Fig. 2 is a sectional view of a conventional photomask material; and
Fig. 3 is a sectional view showing a further embodiment of the invention.

DESCRIPTION OF THE PREFERRED EMBODIMENTS

Fig. 1 is a sectional view showing a photomask material of an embodiment of this invention. In the figure, a silicide film 3 of oxidized transition metal such as molybdenum (Mo), tungsten (W) or tantalum (Ta) is formed to a thickness of approximately 1000Å on a substrate 1 of transparent glass such as quartz. Such oxidized transition metal silicide film (referred to hereinafter as oxidized metal silicide film) 3 can be formed easily by a sputtering process or the like. For example, if sputtering is applied to molybdenum silicide ($MoSi_2$) as a target by plasma containing Argon (Ar) gas and oxygen ($O_2$) gas mixed by any suitable ratio, molybdenum oxide silicide film ($MoSi_2Ox$) in which $MoSi_2$ and $O_2$ are combined by a suitable ratio can be obtained. For example, if the value of x intended to be "0.1", $O_2$ gas of 2 to 5% is added to Ar gas. Otherwise, a molybdenum oxide silicide film may be formed by sputtering by Ar plasma using a target of molybdenum oxide silicide formed in advance by a suitable ratio. As the value x in $MoSi_2Ox$ increases, the reflection factor is lowered, but the film gradually becomes insulated. In manufacturing a mask by means of electron beam (EB), as a problem of charging up does not arise, it is necessary to control the value x so that molybdenum oxide silicide film may be lower than several KΩ. For example, if x is lower than 0.1, the reflection factor becomes lower than 30% and the resistance becomes several KΩ and thus, favorable conditions are established. In addition, since reflection of light is particularly intense on the surface of the film, $O_2$ may be controlled so that the concentration of x may be increased near the surface. On the other hand, in case of the printing by irradiation of light, since there is no problem of charging up, the oxidized metal silicide film 3 may be a complete insulator. Concretely, x may be about "1".

Thus, if an oxidized metal silicide film is used as a mask material as described above, the reflection factor is much lowered as compared with a conventional case using an ordinary metal silicide film as a mask material and consequently, lowering of the resolution of patterns due to diffused reflection can be avoided. Furthermore, the silicide metal has good adhesion to a transparent substrate ($SiO_2$, $Al_2O_3$ etc.), particularly a quartz glass substrate, and has a merit that the lifetime of the photomask is lengthened (in other words, fine patterns will not peel off at the time of rinsing the mask).

In addition, the oxidized metal silicide film 3 can be easily etched in a dry etching process. For example, in the case of molybdenum oxide silicide, mixed gas of $CF_4 + O_2$ (2%) or $CCl_4 + O_2$ is used and under the conditions of a degree of vacuum of 0.2 Torr and 300 W, etching is completed at an etching speed of approximately 500Å/min. At this time, the molybdenum oxide silicide film ($MoSi_2Ox$) is volatilized, leaving reaction products such as $MoOCl_4$ or $SiOCl_4$. The etching speed in this case is approximately five times as fast as the dry etching speed in a conventional Cr film and, therefore, it is understood that such fast etching speed is suited for mass production of photomasks. Prior to the dry etching process, photoresist or EB resist is coated to a thickness of 4000 to 6000Å on the oxidized metal silicide film 3 and then patterns are printed on the transparent glass substrate 1 by irradiation of light or EB. In this case, a problem of charging up does not arise even in the case of using EB, since the oxidized metal silicide film 3 has conductivity of several K as described above.

As described in the foregoing, in this embodiment a silicide film of oxidized transition metal is formed on a transparent substrate. In consequence, patterns of high resolution can be formed and dry etching can be easily done at a high etching speed. Thus, a photomask material having high reliability can be obtained.

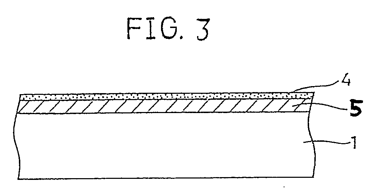

Fig. 3 is a sectional view of a photomask material of another embodiment of the present invention. In Fig. 3, on a transparent glass substrate 1 of quartz glass or the like, a silicide film 5 of a transition metal such as molybdenum (Mo), tungsten (W), or tantalum (Ta) is formed to have a thickness of approximately 1000Å by a sputtering process or the like. On the transition metal silicide film (hereinafter referred to as the metal silicide film) 5, an oxidized transition metal silicide film 4 is is formed to have a thickness of 100 to 200Å. As the oxidized transition metal silicide film (hereinafter referred to as the oxidized metal silicide film) 4, a silicide film of oxidized molybdenum

(MoSi$_2$Ox), a silicide film of oxidized tungsten (WSi$_2$Ox), a silicide film of oxidized titanium (TiSi$_2$Ox) or the like is used. For example, an oxidized molybdenum silicide film (MoSi$_2$Ox) can be formed by combination of MoSi$_2$ and O$_2$ with an appropriate ratio by a sputtering process using a plasma containing argon (Ar) and oxygen (O$_2$) mixed at an arbitrary ratio with molybdenum silicide (MoSi$_2$) as a target. An oxidized molybdenum silicide film can be also formed by sputtering using an Ar plasma with a target of oxidized molybdenum silicide formed beforehand at an appropriate ratio. If the value of x in MoSi$_2$Ox becomes large, the reflection factor is lowered but the film becomes gradually insulated. For manufacturing a mask by an electron beam (EB), a problem of charging up has to be considered. However, since the oxidized metal silicide film 4 has a thickness of only approximately 100 to 200Å as described above, the electron beam EB (10 to 20 KeV) attains the lower metal silicide film 5 and, therefore, even if x is a large value, said problem does not arise. Accordingly, the oxidized metal silicide film 4 may be a complete insulator, concretely, x may be about "1". In this case, said sputtering process is performed using a plasma containing Ar gas and O$_2$ gas mixed at a ratio of "1:1".

As described previously in connection with the prior art, if only the metal silicide film is used as a mask material, the resolution of the pattern is decreased. By contrast, if the oxidized metal silicide film 4 is formed on the metal silicide film 5 as described above, a high resolution can be obtained since the oxidized metal silicide film 4 has a low reflection characteristic. In addition, a silicified metal film has good adhesion to a transparent substrate (of SiO$_2$, Aℓ$_2$O$_3$ or the like), particularly a quartz glass substrate. Consequently, when it is used as a photomask, such a photomask has an advantage that a long lifetime is assured (in other words, the fine patterns will hardly be detached by rinsing the mask).

In addition, the metal silicide film 5 and the oxidized metal silicide film 4 can be easily etched by a dry etching process. For example, in the case of molybdenum silicide, etching is completed with a speed of approximately 1000Å/min under the conditions of a degree of vacuum of 0.2 Torr and electric power of 300 W using a gas of mixture of CF$_4$ + O$_2$ (2%). Although the etching speed of the oxidized metal silicide film 4 such as an oxidized molybdenum silicide film is a little slower than that of the metal silicide film 5, the oxidized metal silicide film 4 is as thin as 100 to 200Å and, therefore, etching can be applied easily. Accordingly, the etching speed of the above described embodiment is approximately ten times as fast as the dry etching speed of a conventional case using a Cr film and it can be understood that the embodiment of the present invention is suited for mass production of photomasks. In the above described embodiment, prior to the dry etching, a photoresist or an EB resist of a thickness of 4000 to 6000Å is coated on the oxidized metal silicide film 4 and after that, patterns are formed on the transparent glass substrate 1 using a light or an EB. If an EB is used for patterning, a problem of charging up does not arise since the oxidized metal silicide film 4 is as thin as approximately 100 to 200Å.

As described in the foregoing, in this embodiment a silicide film of a transition metal is formed on a transparent substrate and silicide film of an oxidized transition metal is further formed on the above stated transition metal silicide film. As a result, patterns are formed with a high resolution and good adhesion to the transparent substrate is obtained. Furthermore, dry etching can be applied easily with an increased speed. Thus, a photomask material of high quality suited for mass production can be obtained.

Although the present invention has been described and illustrated in detail, it is clearly understood that the same is by way of illustration and example only and is not to be taken by way of limitation, the scope of the present invention being limited only by the terms of the appended claims.

## Claims

1. Photomask material to be used for manufacturing a semiconductor device, comprising
   a transparent substrate (1), and
   a film of oxidized transition metal silicide (3,4) formed over said transparent substrate.

2. Photomask material as claimed in claim 1, further comprising a film of transition metal silicide (4) formed on said transparent substrate under said film of oxidized transition metal silicide (5).

3. Photomask material as claimed in claim 2, wherein the transition metal of said transition metal silicide film (4) is the transition metal of said film of oxidized transition metal silicide (5).

4. Photomask material as claimed in any preceding claim, wherein a said transition metal is molybdenum (Mo) or tantalum (Ta) or tungsten (W).

5. Photomask material as claimed in any preceding claim, wherein said transparent substrate is composed of quartz glass or sapphire.

6. Photomask material as claimed in any preceding claim in the form of a photomask, wherein the or each said film (3; 4,5) defines a semiconductor pattern on said substrate (1).

7. Photomask material as claimed in claim 6, wherein at least one dimension of said pattern is below one micron.

8. Photomask material as claimed in claim 6 or claim 7 intended to be located in an optical path between a radiation source and a semiconductor wafer, wherein the outer surface of said film of oxidized transition metal silicide (3,5) is intended to be exposed to radiation reflected from said semiconductor wafer back towards said source.

9. A method of forming a photomask made from a transparent substrate (1) and a film of oxidised transition metal silicide (3,5) formed over said transparent substrate, wherein the film defines a semiconductor pattern on said substrate, said method including the step of exposing an area of said film of oxidized transition metal silicide to a plasma containing oxygen and a halocarbon so as to remove, in said area, said transition metal and silicon as oxyhalides.

10. A photomask comprising a film of transition metal silicide (5) formed in a pattern over a transparent substrate (1) and a further film (4) formed over said film of transition metal silicide which is less reflective than said film of transition metal silicide.

## Revendications

1. Matériau de photomasque à utiliser pour la fabrication d'un dispositif à semi-conducteurs, comprenant
   un substrat transparent (1), et
   une pellicule d'un siliciure de métal de transition oxydé (3, 4) formée sur le substrat transparent.

2. Matériau de photomasque selon la revendication 1, comprenant de plus une pellicule de siliciure de métal de transition (4) formée sur le substrat transparent sous la pellicule du siliciure de métal de transition oxydé (5).

3. Matériau de photomasque selon la revendication 2, dans lequel le métal de transition de la pellicule de siliciure de métal de transition (4) est le métal de transition de la pellicule du siliciure de métal de transition oxydé (5).

4. Matériau de photomasque selon l'une quelconque des revendications précédentes, dans lequel un métal de transition est le molybdène (Mo) ou le tantale (Ta) ou le tungstène (W).

5. Matériau de photomasque selon l'une quelconque des revendications précédentes, dans lequel le substrat transparent est constitué par un verre de quartz ou un saphir.

6. Matériau de photomasque selon l'une quelconque des revendications précédentes sous la forme d'un photomasque, dans lequel la ou chaque pellicule (3 ; 4, 5) définit un dessin de semi-conducteurs sur le substrat (1).

7. Matériau de photomasque selon la revendication 6, dans lequel au moins une dimension du dessin est inférieure à un micron.

8. Matériau de photomasque selon la revendication 6 ou 7 destiné à être agencé dans la voie optique entre une source de radiation et une pastille à semi-conducteurs, dans lequel la surface extérieure du film du siliciure de métal de transition oxydé (3, 5) est destinée à être exposée à la radiation réfléchie par la pastille à semi-conducteurs en retour vers la source.

9. Procédé de formation d'un photomasque réalisé à partir d'un substrat transparent (1) et d'une pellicule de siliciure de métal de transition oxydé (3, 5) formée sur le substrat transparent, dans lequel la pellicule définit un dessin à semi-conducteurs sur le substrat, le procédé comprenant l'étape consistant à exposer une zone de la pellicule du siliciure de métal de transition oxydé, un plasma contenant de l'oxygène et un carbone halogéné de façon à enlever, dans cette zone, le métal de transition et le silicium sous forme d'oxyhalogénures.

10. Photomasque comprenant une pellicule de siliciure de métal de transition (5) formée dans un dessin sur un substrat transparent (1) et une pellicule supplémentaire (4) formée sur la pellicule du siliciure de métal de transition qui est moins réfléchissante que la pellicule du siliciure de métal de transition.

## Patentansprüche

1. Photomaskenmaterial zur Benutzung bei der Herstellung einer Halbleitereinrichtung, mit einem transparenten Substrat (1) und einem über dem transparenten Substrat gebildeten Film (3, 4) aus einem Silizid eines Übergangsmetalles.

2. Photomaskenmaterial nach Anspruch 1, weiter mit einem Film aus einem auf dem transparenten Substrat unter dem Film des oxidierten Übergangsmetallsilizides (5) gebildeten Film (4) eines Silizides eines Übergangsmetalles.

3. Photomaskenmaterial nach Anspruch 2, bei dem das Übergangsmetall des Übergangsmetallsilizidfilmes (4) das Übergangsmetall des oxidierten Übergangsmetallsilizides (5) ist.

4. Photomaskenmaterial nach einem der vorhergehenden Ansprüche, bei dem das Übergangsmetall Molybdän (Mo) oder Tantal (Ta) oder Wolfram (W) ist.

5. Photomaskenmaterial nach einem der vorhergehenden Ansprüche, bei dem das transparente Substrat aus Quarzglas oder Saphir zusammengesetzt ist.

6. Photomaskenmaterial nach einem der vorhergehenden Ansprüche in der Form einer Photomaske, bei dem der oder jeder Film (3; 4, 5) ein Halbleitermuster auf dem Substrat (1) bildet.

7. Photomaskenmaterial nach Anspruch 6, bei dem mindestens eine Abmessung des Musters unter einem Mikrometer liegt.

8. Photomaskenmaterial nach Anspruch 6 oder 7, das in einem optischen Weg zwischen einer Strahlungsquelle und einem Halbleiterwafer angeordnet werden soll, bei dem die äußere Oberfläche des Filmes des oxidierten Übergangsmetallsilizides (3, 5) der von dem Halbleiterwafer zurück zu der Quelle reflektierten Strahlung ausgesetzt werden soll.

9. Verfahren zum Bilden einer Photomaske aus einem transparenten Substrat (1) und einem über dem transparenten Substrat gebildeten oxidierten Silizid (3, 5) eines Übergangsmetalles, bei dem der Film ein Halbleitermuster auf dem Substrat definiert, wobei das Verfahren die Schritte aufweist des Aussetzens einer Fläche des Filmes des oxidierten Übergangsmetallsilizides einem Sauerstoff und ein Halogenkarbon enthaltenden Plasma, so daß in der Fläche das Übergangsmetall und Silizium als Oxihalogenide entfernt werden.

10. Photomaske mit einem Film eines in einem Muster über einem transparenten Substrat (1) gebildeten Übergangsmetallsilizidfilm (5) und einem weiteren über dem Film des Übergangsmetallsilizides gebildeten Film (4), der weniger reflektierend als der Film des Übergangsmetallsilizides ist.

FIG.1

3

1

FIG.2

2

1

FIG. 3